# EUROPEAN PATENT SPECIFICATION

(11) **EP 0 331 555 B1**
(45) Date of publication and mention of the grant of the patent: **28.05.1997**
(21) Application number: 89400470.4
(22) Date of filing: 20.02.1989
(51) Int. Cl.: H01L 21/306, H01L 21/316

(54) **Gettering treatment process**
Getterprozess
Procédé de traitement gettering

(30) Priority: 26.02.1988 JP 41895/88
(43) Date of publication of application: 06.09.1989
(73) Proprietor: FUJITSU LIMITED, Kawasaki-shi, Kanagawa 211 (JP)
(72) Inventor: Sugino, Rinshi, Atsugi-shi Kanagawa 243-02 (JP); Nara, Yasuo, Zama-shi Kanagawa 228 (JP); Ito, Takashi, Kawasaki-shi Kanagawa 214 (JP)
(74) Representative: Joly, Jean-Jacques

(56) References cited:
- EP-A- 0 227 839
- EP-A- 0 246 802
- SOLID STATE TECHNOLOGY, vol. 22, no. 8, August 1979, pages 113-119; J. MONKOWSKI: "Role of chlorine in silicon oxidation"
- JAPANESE JOURNAL OF APPLIED PHYSICS. SUPPLEMENTS 16TH INT. CONF. SOLID STATE DEVICES AND MATERIALS, Kobe, 30th August - 1st September 1984, pages 50-51, Tokyo, JP; K. HORIOKA et al.: "XeCl excimer laser oxidation of Si employing 02/Cl2 gas mixture"
- SOLID-STATE TECHNOLOGY, vol. 25, no. 7, July 1982, pages 83-86, Port Washington, New York, US; T. HATTORI: "Chlorine oxidation and annealing in the fabrication of high-performance LSI devices"

## Description

### BACKGROUND OF THE INVENTION

### 1. Field of the Invention

The present invention relates to a gettering treatment process for an insulating layer (e.g., a silicon oxide thin layer) of a semiconductor device, and more particularly, to a gettering process for removing harmful impurities, such as mobile ions and heavy metals, by trapping (capturing) these impurities in a silicon oxide layer (e.g., gate oxide layer) formed by thermally oxidizing silicon (silicon substrate).

### 2. Description of the Related Art

In the production of large-scale integration (LSI) devices comprising metal-oxide-semiconductor field-effect transistors (MOSFETs), e.g., dynamic random access memory (RAM) devices, a gate oxide layer is formed by thermally oxidizing a silicon substrate, and a gate electrode of polycrystalline silicon or aluminum is formed on the oxide layer. Before the formation of the gate electrode, an etching of the oxide layer and an ion implantation are usually carried out, whereby resist layers are deposited on the oxide layer, exposed, developed, and removed. As a result, mobile ions, such as sodium, potassium and lithium, and heavy metals, such as iron, nickel, and chromium are able to easily penetrate the oxide layer from the resist layers, an etchant, a washing water, aluminum, polycrystalline silicon, and the inside surfaces of pipes through which gas is passed. The oxide layer containing such ions and metals imposes restrictions on the design of semiconductor devices and affects the ideal characteristics of the MOS devices.

An HCl oxidation process has been adopted for trapping and neutralizing the mobile ions in the gate oxide layer. In this HCl oxidation process, a small amount of hydrogen halide (mainly hydrogen chloride: HCl) is added to the oxygen during a thermal oxidation of a silicon substrate(for example, see R.J. Kriegler et al, "The Effect of HCl and Cl₂ on the Thermal Oxidation of Silicon", J. Electrochem. Soc. Vol. 119, No. 3 (1972), pp.388 - 392, and R.S. Romen and P.H. Rubinson, "Hydrogen Chloride and Chlorine Gettering:", ibid., pp. 747 - 752).

In a conventional HCl oxidation process, chlorine exists at the interface of silicon substrate and oxide (SiO₂) layer and traps and settles mobile ions (e.g., Na) moved to the interface, as NaCl. However, heavy metals (Fe, Ni, Cr), which do not move in the oxide layer, behave in a different manner to that of the mobile ions, and affect the characteristics of MOS devices. Namely, the HCl oxidation process has no substantial affect on the heavy metals in the oxide layer and contaminants (i.e., the above-mentioned metal impurities) penetrating the oxide layer from the surface thereof after the formation of the oxide layer.

In the case of a stacked capacitor of a dynamic RAM cell, a polycrystalline silicon layer is thermally oxidized to form an oxide (SiO₂) layer as an insulating (dielectric) layer of the capacitor, and due to recent demands to make the oxide layer thinner and to increase the reliability thereof, the harmful metal impurities in the oxide layer must be trapped or removed.

In a paper by T. Hattori published in Solid State Technology volume 25, No. 7, July 1982, pages 83-86, it is explained how an addition of a chlorine-containing compound such as HCl to the oxidizing or annealing ambient is beneficial in the manufacture of MOS and bipolar LSIs.

Finally, there is described in EP-A-0 246 802 a process for cleaning the surface of a semiconductor substrate by first etching the surface with an atmosphere containing a free halogen or a halogen compound, irradiated with UV rays, followed by wet solution cleaning.

### SUMMARY OF THE INVENTION

An object of the present invention is to provide a gettering treatment process for trapping the harmful metal impurities (mobile ions and heavy metals) present in an insulating layer (particularly, a silicon oxide layer formed by thermally oxidizing the silicon) and which penetrate therein after the formation thereof, to eliminate the harmful affects of the metal impurities.

Another object of the present invention is to improve and increase the characteristics and reliability of a gate oxide layer of a MOS device or a dielectric oxide layer of a stacked capacitor of a dynamic RAM device.

The above-mentioned and other objects of the present invention are obtained by providing a gettering treatment process comprising the step of irradiating an insulating layer, e.g., a silicon oxide thin layer formed by thermally oxidizing silicon, in a chlorine-containing gas atmosphere, with an ultraviolet light to generate chlorine radicals which penetrate uniformly the silicon layer and trap metal impurities in the layer.

Preferably, the insulating layer (silicon oxide thin layer or silicon nitride thin layer) is heated to a temperature of from 100 to 400°C, as the penetration of chlorine radicals is promoted by such heating.

### BRIEF DESCRIPTION OF THE DRAWINGS

The present invention will become more apparent from the description of the preferred embodiments set forth below with reference to the accompanying drawings, in which:
Fig. 1 is a schematic sectional and partial view of an incomplete MOS device;
Fig. 2 is a schematic view of an apparatus for performing a gettering treatment in accordance with the present invention;
Fig. 3 is a schematic enlarged sectional view of the silicon oxide layer subjected to the gettering treatment;
Fig. 4 is a schematic sectional and partial view of a stacked capacitor of a dynamic RAM cell;
Fig. 5 is a graph showing a distribution of breakdown voltages of metal-oxide-silicon (MOS) diodes subjected to the gettering treatment;
Fig. 6 is a graph showing a distribution of breakdown voltages of MOS diodes not subjected to the gettering treatment;
Fig. 7 is an SIMS (secondary ion mass spectrometer) chart of a MOS diode subjected to the gettering treatment; and
Fig. 8 is an SIMS chart of a MOS diode not subjected to the gettering treatment.

### DESCRIPTION OF THE PREFERRED EMBODIMENTS

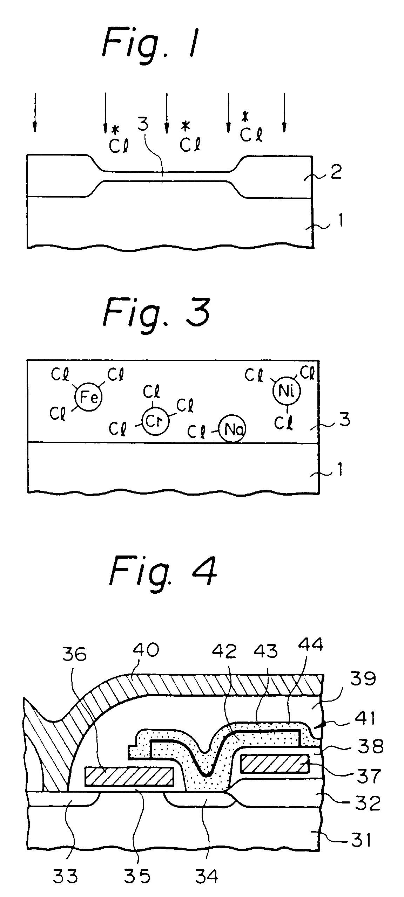

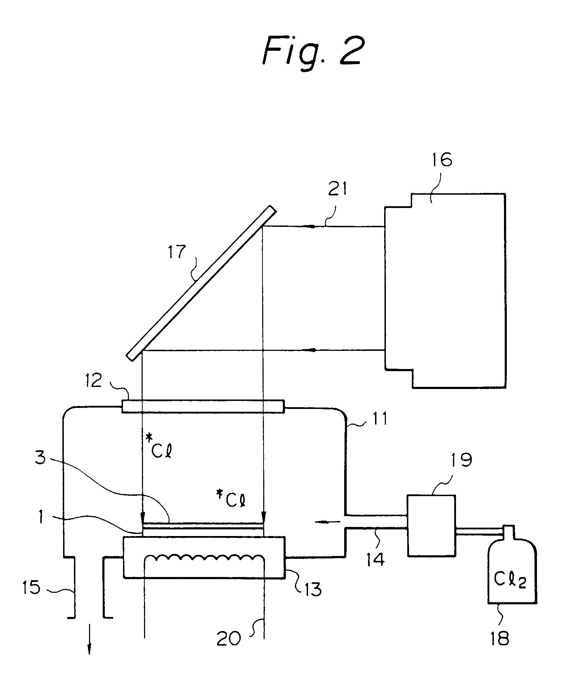

Referring to Fig. 1 the incomplete MOS device comprises a silicon substrate 1, a field (thick) oxide layer 2, and a gate (thin) oxide layer 3. In the product process thereof, the silicon substrate 1 is first cleaned to remove contaminants from the surface thereof, by a conventional cleaning treatment, and then the field oxide layer 2 is formed by locally (selectively) oxidizing the silicon substrate 1 in a conventional manner using a mask to prevent oxidation. Subsequently, the mask is removed and the surface of the substrate 1 exposed thereby is cleaned. The silicon substrate 1 is then heated in an oxygen atmosphere, to oxidize the exposed silicon, whereby the gate oxide layer 3 (having a thickness of, e.g., from 2 to 100 nm) is formed, as shown in Fig. 1. Instead of the silicon oxide thin layer, it is possible to form a silicon nitride thin layer by thermally nitriding the exposed surface of the silicon substrate in a nitrogen-containing atmosphere.

The substrate 1 with the oxide layers 2 and 3 is set in an apparatus shown in Fig. 2 for gettering treatment. The apparatus comprises a reaction chamber 11 having a transparent window 12 of quartz, a holder 13 of ceramic, an inlet pipe 14, and an outlet pipe 15, an ultraviolet light source 16 of a murcury lamp or an eximer laser (e.g., Ar - F eximer laser, and Xe-Cl eximer laser), a mirror 17, a chlorine gas source 18, and a flowmeter 19. The holder 13 is provided with a heater 20. Instead of the holder 13, a transparent holder may be used and an infrared heating element arranged thereunder. The silicon substrate 1 with the oxide layer 2 is put on the holder 13 and heated to a temperature of from 100 to 400°C, and simultaneously, a high-purity chlorine (Cl₂) gas or a hydrogen chloride (HCl) gas is fed from the gas source 18 through the flowmeter 19 and the inlet pipe 14 into the reaction chamber 11. The gas flows out of the reaction chamber 11 through the outlet pipe 15. Under the above conditions, an ultraviolet light 21 having a wavelength of from 200 to 300 nm is emitted from the light source 16 and is reflected by the mirror 17 onto the oxide layer 2, through the transparent window 12, at an irradiation energy of about 20 mW/cm². The ultraviolet light 21 excites and dissociates the chlorine gas, to thereby generate chlorine radicals (indicated by *Cl in Fig. 3) in the reaction chamber 11. The generated chlorine radicals uniformly penetrate the oxide layer 2 and trap (bond) the mobile ions (e.g., Na) and heavy metals (e.g., Fe, Ni, and Cr), as shown in Fig. 3, within the oxide layer 2, and thus the chlorine additives immobilize the harmful ions and metals, i.e., neutralize the mobile ions, which reduces the effectiveness of the heavy metals as generation-recombination centers for carriers. Therefore, the gettering treatment according to the present invention raises the breakdown voltage of an oxide layer and prolongs a minority carrier generating lifetime at the interface of the oxide layer 2 and the silicon substrate 1.

Thereafter, a gate electrode (not shown) of polycrystalline silicon or aluminum is formed on the oxide layer 2 by a conventional process. It is possible to additionally form another insulating thin layer (not shown) of silicon nitride or tantalum oxide prior to the formation of the gate electrode.

The above-described gettering treatment can be applied to an insulating (oxide) layer of a stack capacitor of a dynamic RAM cell shown in Fig. 4. In this case, the RAM cell comprises a silicon substrate 31, a field oxide layer 32, impurity-doped regions 33 and 34, a gate oxide layer 35, a polycrystalline silicon gate 36, a polycrystalline silicon layer 37, insulating layers 38 and 39, another polycrystalline silicon layer 40, and a stacked capacitor 41. The capacitor 41 consists of a lower polycrystalline silicon electrode 42 connected to the region 34, an insulating layer 43 formed on the electrode 42 by thermal oxidation, and an upper polycrystalline silicon electrode 44. After the formation of the insulating oxide layer 43, the RAM cell is placed in the above-described apparatus, subjected to the gettering treatment using the chlorine gas and ultraviolet light, and the electrode 44 then formed over the insulating oxide layer 43.

### EXAMPLE

MOS diodes were produced on a p-type (100) oriented silicon substrate in the following manner. The substrate was cleaned by a conventional cleaning procedure, and oxidized in a dry oxygen atmosphere at an O₂ flow rate of 6 ℓ/min, at 1000°C, for 15 minutes, to obtain an oxide (SiO₂) layer having a thickness of 20 nm. The substrate with the oxide layer was placed in the apparatus shown in Fig. 2, and subjected to the gettering treatment under the following conditions.
- Heating temperature:: 350°C (by an infrared heating lamp)
- Chlorine gas flow rate:: 50 sccm
- Ultraviolet light:: High pressure mercury lamp
- Irradiation time:: 2 minutes

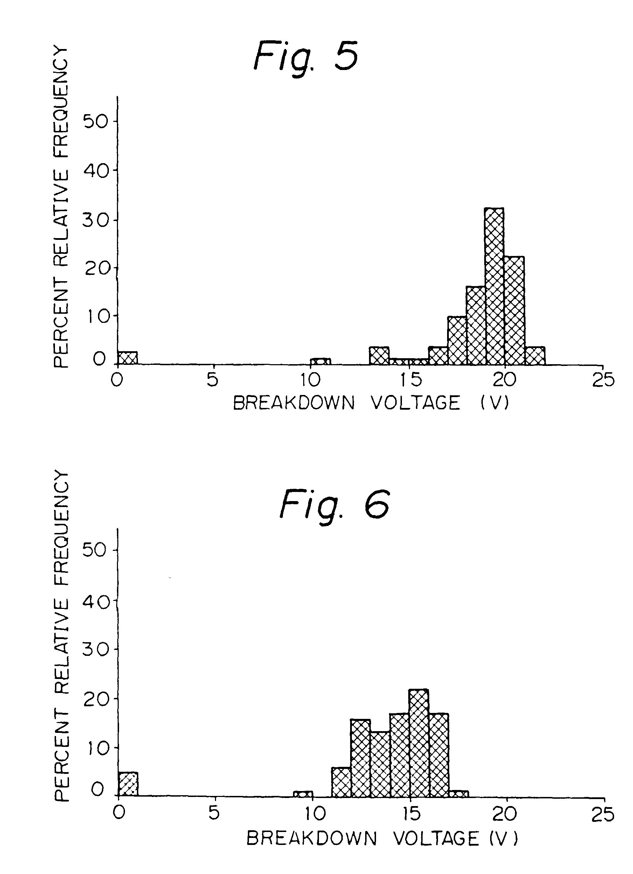

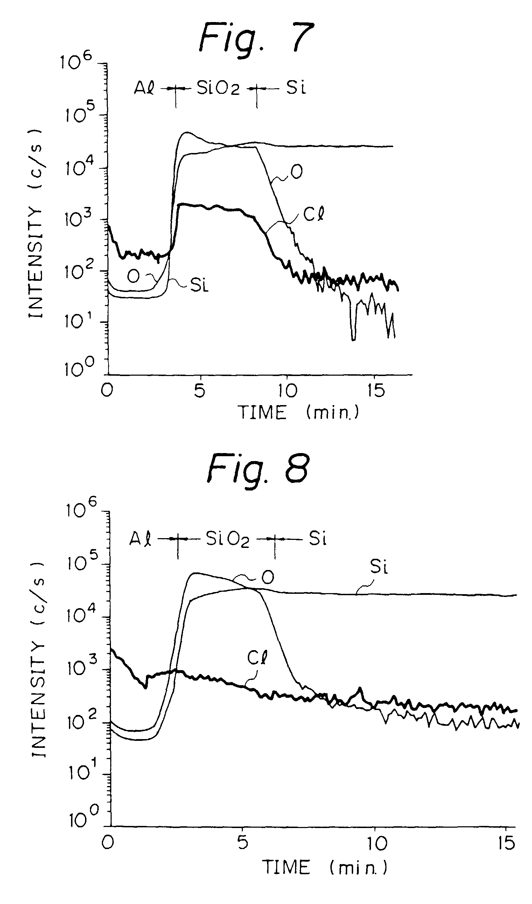

Irradiation energy: 20 mW/cm² at the oxide layer Next, an aluminum layer having a thickness of 600 nm was deposited on the oxide layer by a vacuum evaporation process, and was patterned to form gate electrodes by a photolithographic process. The obtained MOS diodes were subjected to a breakdown test and a minority carrier generating lifetime test, and analyzed by an SIMS, and the results shown in Figs. 5 and 7 were obtained. As comparative examples, MOS diodes were produced by the above-mentioned procedure, except that the gettering treatment was omitted, and were tested and analyzed. The results are shown in Figs. 6 and 8.

As is clear from Figs. 5 and 7, an average breakdown voltage of the MOS diodes subjected to the gettering treatment is higher than that of the comparative MOS diodes not subjected to the gettering treatment. The minority carrier generating lifetime of a MOS diode subjected to the gettering treatment is 1.8 ms, which is longer than the 0.75 ms of a comparative MOS diode, and therefore, a time for which a charge can be held in a RAM cell is prolonged by the gettering treatment. The SIMS analysis was carried out by using xenon (Xe), and the transverse axes of Figs. 7 and 8 indicate a sputtering time (min) and the ordinate axes indicate the intensities of Cl, O, and Si (count per second). As is clear from Fig. 7, chlorine is uniformly contained in the oxide layer subjected to the gettering treatment, at a convex portion of the Cl profile, but the Cl profile of Fig. 8 of the comparative MOS diode does not have a convex portion.

## Claims

1. A gettering treatment process comprising the step of irradiating an ultraviolet light (16) onto an insulating layer (3) in a chlorine-containing gas atmosphere, whereby chlorine radicals are generated and uniformly penetrate said insulating layer (3) to trap metal impurities within said insulating layer (3).

2. A process according to claim 1, wherein said chlorine-containing gas is chlorine gas or hydrogen chloride gas.

3. A process according to claim 1, wherein said insulating layer is a silicon oxide thin layer (3).

4. A process according to claim 3, wherein said silicon oxide thin layer is formed by thermally oxidizing silicon.

5. A process according to claim 4, wherein said silicon oxide thin layer has a thickness of from 2 to 100 nm.

6. A process according to claim 3, wherein said silicon oxide thin layer is heated to a temperature of from 100 to 400°C under said ultraviolet irradiation.

7. A process according to claim 6, wherein said ultraviolet light (16) is irradiated from a mercury lamp or an eximer laser.

8. A process according to claim 4, wherein said silicon oxide thin layer is a gate oxide layer (3) of a MOSFET, and is formed by a thermal oxidation of a silicon substrate (1).

9. A process according to claim 4, wherein said silicon oxide thin layer is a dielectric layer of a stacked capacitor (41) of a dynamic RAM cell, and is formed by a thermal oxidation of a polycrystalline silicon layer.

10. A process for the manufacture of a MOS device comprising a silicon substrate (31) a silicon oxide thin layer, and a gate electrode, wherein said silicon oxide thin layer is produced in accordance with the process set out in claim 8.

11. The process according to claim 10, further comprising the step of providing another insulating thin layer between said silicon oxide thin layer and said gate electrode.

12. A process for the manufacture of a stacked capacitor (41) of a dynamic RAM device comprising a polycrystalline silicon layer (42) for a lower capacitor electrode, a silicon oxide thin layer (43) and an upper capacitor electrode (44), wherein said silicon oxide thin layer (43) is produced in accordance with the process set out in claim 9.

## Patentansprüche

1. Getterbehandlungsverfahren, das den Schritt einer Ultraviolettlicht (16)-Bestrahlung einer Isolierschicht (3) in einer chlorhaltigen Gasatmosphäre aufweist, wodurch Chlorradikale erzeugt werden und die Isolierschicht (3) gleichmäßig durchdringen, um Metallverunreinigungen innerhalb der Isolierschicht (3) einzufangen.

2. Verfahren nach Anspruch 1, bei dem das chlorhaltige Gas Chlorgas oder Wasserstoffchloridgas ist.

3. Verfahren nach Anspruch 1, bei dem die Isolierschicht eine Siliziumoxid-Dünnschicht ist.

4. Verfahren nach Anspruch 3, bei dem die Siliziumoxid-Dünnschicht durch thermische Oxidation von Silizium gebildet wird.

5. Verfahren nach Anspruch 4, bei dem die Siliziumoxid-Dünnschicht eine Dicke von 2 bis 100 nm hat.

6. Verfahren nach Anspruch 3, bei dem die Siliziumoxid-Dünnschicht unter der Ultraviolettbestrahlung auf eine Temperatur von 100 bis 400 °C erhitzt wird.

7. Verfahren nach Anspruch 6, bei dem das Ultraviolettlicht (16) von einer Quecksilberlampe oder einem Eximer-Laser abgestrahlt wird.

8. Verfahren nach Anspruch 4, bei dem die Siliziumoxid-Dünnschicht eine Gateoxidschicht (3) eines MOSFET ist und durch eine thermische Oxidation eines Siliziumsubstrats gebildet wird.

9. Verfahren nach Anspruch 4, bei dem die Siliziumoxid-Dünnschicht eine dielektrische Schicht eines gestapelten Kondensators (41) einer dynamischen RAM-Zelle ist und durch eine thermische Oxidation einer polykristallinen Siliziumschicht gebildet wird.

10. Verfahren und Herstellung einer MOS-Anordnung mit einem Siliziumsubstrat (31), einer Siliziumoxid-Dünnschicht und einer Gateelektrode, bei dem die Siliziumoxid-Dünnschicht entsprechend dem in Anspruch 8 angegebenen Verfahren erzeugt wird.

11. Verfahren nach Anspruch 10, das weiter den Schritt des Vorsehens einer zusätzlichen isolierenden Dünnschicht zwischen der Siliziumoxid-Dünnschicht und der Gateelektrode aufweist.

12. Verfahren zur Herstellung eines gestapelten Kondensators (41) einer dynamischen RAM-Anordnung mit einer polykristallinen Siliziumschicht (42) für eine untere Kondensatorelektrode, einer Siliziumoxid-Dünnschicht (43) und einer oberen Kondensatorelektrode (44), bei dem die Siliziumoxid-Dünnschicht (43) entsprechend dem in Anspruch 9 angegebenen Verfahren erzeugt wird.

## Revendications

1. Procédé de traitement par effet getter comprenant l'étape d'irradiation par une lumière ultraviolette (16) d'une couche isolante (3) dans une atmosphère gazeuse contenant du chlore, étape dans laquelle des radicaux de chlore sont générés et pénètrent uniformément dans ladite couche isolante (3) pour piéger les impuretés métalliques se trouvant dans ladite couche isolante (3).

2. Procédé selon la revendication 1, dans lequel ledit gaz contenant du chlore est du chlore gazeux ou du chlorure d'hydrogène gazeux.

3. Procédé selon la revendication 1, dans lequel ladite couche isolante est une couche mince en oxyde de silicium (3).

4. Procédé selon la revendication 3, dans lequel ladite couche mince en oxyde de silicium est formée par oxydation thermique de silicium.

5. Procédé selon la revendication 4, dans lequel ladite couche mince en oxyde de silicium a une épaisseur située entre 2 et 100 nm.

6. Procédé selon la revendication 3, dans lequel ladite couche mince en oxyde de silicium est chauffée à une température située entre 100 et 400°C en présence de ladite irradiation par les ultraviolets.

7. Procédé selon la revendication 6, dans lequel ladite lumière ultraviolette (16) est émise par une lampe au mercure ou un laser à excimère.

8. Procédé selon la revendication 4. dans lequel ladite couche mince en oxyde de silicium est une couche grille en oxyde (3) d'un MOSFET et est formée par oxydation thermique d'un substrat en silicium (1).

9. Procédé selon la revendication 4, dans lequel ladite couche mince en oxyde de silicium est une couche diélectrique d'un condensateur lamellaire (41) d'une cellule de mémoire RAM dynamique et est formée par oxydation thermique d'une couche en silicium polycristallin.

10. Procédé pour la fabrication d'un dispositif MOS comprenant un substrat en silicium (31), une couche mince en oxyde de silicium et une électrode grille, dans lequel ladite couche mince en oxyde de silicium est produite selon le procédé défini dans la revendication 8.

11. Procédé selon la revendication 10. comprenant en outre une étape pour fournir une autre couche mince isolante entre ladite couche mince en oxyde de silicium et ladite électrode grille.

12. Procédé de fabrication d'un condensateur lamellaire (41) d'un dispositif de mémoire RAM dynamique comprenant une couche en silicium polycristallin (42) pour une électrode inférieure de condensateur, une couche mince en oxyde de silicium (43) et une électrode supérieure de condensateur (44). dans lequel ladite couche mince en oxyde de silicium (43) est produite selon le procédé défini dans la revendication 9.
